# FASCICULE DE BREVET EUROPEEN

(11) **EP 3 996 223 B1**
(45) Date de publication et mention de la délivrance du brevet: **04.12.2024**
(21) Numéro de dépôt: 21204957.1
(22) Date de dépôt: 27.10.2021
(51) Int. Cl.: H02G 15/34, H01B 12/16, H01R 4/68

(54) **BOÎTIER CRYOSTAT POUR CIRCUIT CÂBLÉ SUPRACONDUCTEUR, ET CIRCUITS CÂBLÉS SUPRACONDUCTEURS ASSOCIÉS**
KRYOSTATGEHÄUSE FÜR SUPRALEITENDE VERDRAHTETE SCHALTUNGEN UND ENTSPRECHENDE SUPRALEITENDE VERDRAHTETE SCHALTUNGEN
CRYOSTAT HOUSING FOR WIRED SUPERCONDUCTOR CIRCUIT, AND ASSOCIATED WIRED SUPERCONDUCTOR CIRCUITS

(30) Priorité: 05.11.2020 FR 2011360
(43) Date de publication de la demande: 11.05.2022
(73) Titulaire: Nexans, 92400 Courbevoie (FR)
(72) Inventeur: LALLOUET, Nicolas, 62360 BAINCTHUN (FR); LEGRAND, Loïc, 62370 AUDRUICQ (FR)
(74) Mandataire: Ipsilon

(56) Documents cités:
- EP-A1- 2 602 796
- EP-A1- 3 065 243
- WO-A1-2010/039513
- US-A1- 2012 186 854

## Description

### Domaine technique

La présente invention concerne le domaine général des circuits câblés supraconducteurs, et plus précisément un boîtier cryostat particulièrement adapté pour différents circuits câblés supraconducteurs.

### Arrière-plan technologique

Un câble supraconducteur permet de transporter des courants électriques de forte intensité avec une section de câble beaucoup plus faible que celle d'un câble classique composé d'un conducteur électrique résistif, tout en limitant les pertes électriques le long du câble, notamment les pertes par effet Joule puisque ce phénomène est extrêmement faible en supraconductivité.

Un câble supraconducteur est classiquement constitué d'au moins un fil supraconducteur central entouré par une enveloppe cryogénique. L'enveloppe cryogénique comporte par exemple deux enveloppes concentriques isolées thermiquement entre elles par du vide. Un fluide de refroidissement, tel que de l'hélium ou de l'azote, sous forme liquide ou gazeuse, contenu à l'intérieur de l'enveloppe cryogénique, refroidit le fil supraconducteur central jusqu'à atteindre une température inférieure à la température dite critique pour laquelle ce fil passe dans un état de supraconductivité.

Il est connu d'utiliser des circuits câblés composés soit d'un unique câble supraconducteur de grande longueur, soit d'une pluralité de câbles supraconducteurs connectés les uns aux autres en série, de manière à réaliser un transport de courant de forte intensité sur une longue distance. Pour ce type de circuit, si le liquide de refroidissement est injecté sous pression et à la température critique à un point d'injection situé à une extrémité du circuit, il n'est pas garanti d'une part, que la pression reste suffisante pour permettre la circulation du fluide de refroidissement sur toute la longueur du circuit, et d'autre part, que le liquide de refroidissement ne s'échauffe pas pour atteindre une température supérieure à la température critique au fur et à mesure que l'on s'éloigne dans le circuit du point d'injection du fluide.

D'autres circuits câblés supraconducteurs sont connus pour former des boucles supraconductrices fermées générant de forts champs magnétiques. Un tel circuit comporte un câble supraconducteur comprenant, dans une unique enveloppe cryogénique, un fil supraconducteur enroulé sur plusieurs tours, le fil étant composé soit d'un fil supraconducteur unique, soit d'une succession de fils élémentaires supraconducteurs connectés en série, chaque fil élémentaire formant un tour de la bobine. Une telle bobine supraconductrice peut par exemple être utilisée, comme décrit notamment dans le document EP 2 732 075 B1, comme circuit électrique secondaire dans une aluminerie, pour compenser le champ magnétique créé par un circuit électrique principal transportant un courant d'électrolyse alimentant une série de cuves d'électrolyse destinées à la production d'aluminium et formant une ou plusieurs files. Dans ce type de bobine supraconductrice, une première extrémité du fil supraconducteur (ou du fil élémentaire constituant le premier tour) et une deuxième extrémité du fil supraconducteur (ou du fil élémentaire constituant le dernier tour) doivent être reliées électriquement aux deux pôles électriques d'une station d'alimentation électrique délivrant un courant d'alimentation d'intensité prédéterminé. Le nombre de tours effectué par le fil supraconducteur (ou le nombre de fils élémentaires supraconducteurs connectés en série) dépend de la valeur du courant d'alimentation et de la valeur du champ magnétique que l'on souhaite générer. A titre d'exemple non limitatif, une bobine supraconductrice comportant un fil supraconducteur enroulé sur 21 tours passant côte à côte à l'intérieur de l'enveloppe cryogénique unique (ou 21 fils élémentaires supraconducteurs connectés en série) et alimentée par un courant de 5 kA, permet de générer un champ magnétique correspondant à 105 kA. Ici encore, la longueur de l'enveloppe cryogénique unique renfermant l'enroulement supraconducteur peut être assez importante (de l'ordre de plusieurs centaines de mètres) de sorte qu'il est nécessaire de prévoir que le liquide de refroidissement destiné à circuler dans la boucle soit injecté à une pression suffisante et reste en deçà de la température critique.

EP 2 602 796 A1 D3 divulgue le préambule de la revendication 1.

### Résumé de l'invention

La présente invention a pour but de proposer des solutions de boîtiers cryostat pour circuits câblés supraconducteurs particulièrement adaptées pour la gestion des liquides de refroidissement.

Plus particulièrement, la présente invention a pour premier objet un boîtier cryostat pour circuit câblé supraconducteur selon la revendication 1.

Dans un mode de réalisation possible, ladite cloison séparatrice intègre une pluralité de cavités formant chacune une traversée de cloison pour autoriser le passage d'un fil d'une pluralité de fils supraconducteurs, et une ouverture d'accès par cavité pour permettre un remplissage séparé de chaque cavité par injection du matériau isolant électrique dans chaque cavité.

En variante, ladite cloison séparatrice intègre une unique cavité formant une pluralité de traversées de cloison autorisant chacune le passage d'un fil d'une pluralité de fils supraconducteurs, le remplissage de l'unique cavité par injection du matériau isolant électrique sous forme liquide polymérisable permettant de rendre chaque traversée de cloison étanche aux fluides de refroidissement.

Dans un mode de réalisation possible, le boîtier cryostat comporte au moins une cinquième ouverture pour permettre l'injection, à partir d'une terminaison électrique d'entrée externe au boîtier cryostat, d'un courant électrique sur une première extrémité d'un fil supraconducteur traversant la cloison séparatrice.

La cinquième ouverture peut permettre en outre de récupérer un courant électrique à une deuxième extrémité du fil supraconducteur sur une terminaison électrique de sortie externe au boîtier cryostat. En variante, le boîtier cryostat comporte une sixième ouverture pour permettre de récupérer un courant électrique à une deuxième extrémité du fil supraconducteur sur une terminaison électrique de sortie externe au boîtier cryostat.

Dans un mode de réalisation possible, ladite au moins une traversée de cloison étanche peut être dimensionnée pour accueillir un connecteur reliant en série deux fils élémentaires supra conducteur composant ledit au moins un fil supraconducteur.

Dans un mode de réalisation possible, ladite au moins une traversée de cloison comporte deux extrémités sensiblement cylindriques s'étendant transversalement de part et d'autre de la cloison séparatrice, chaque extrémité étant équipée d'un anneau de centrage en matériau électriquement isolant.

La présente invention a également pour objets différents circuits électriques câblés supraconducteurs utilisant différents modes de réalisation du boîtier cryostat :

Un premier circuit électrique câblé supraconducteur conforme à l'invention est défini par la revendication 9.

Ledit au moins un connecteur peut être placé dans le premier espace interne ou dans le deuxième espace interne du boîtier cryostat. En variante, ledit au moins un connecteur est placé dans ladite au moins une traversée de cloison étanche.

Le circuit comporte en outre avantageusement un dispositif de gestion de fluides de refroidissement externe au boîtier cryostat, configuré pour recevoir le premier fluide de refroidissement sortant de la troisième ouverture, et pour injecter le deuxième liquide de refroidissement sous pression au travers de la quatrième ouverture.

Un autre circuit électrique câblé supraconducteur conforme à l'invention, et formant une boucle électrique supraconductrice fermée est défini à la revendication 13.

Dans un mode de réalisation possible, chaque tour dudit fil supraconducteur est constitué d'un fil élémentaire supraconducteur, deux fils élémentaires supraconducteurs successifs étant reliés en série par un connecteur placé à l'intérieur du boîtier cryostat.

Dans un mode de réalisation possible, au moins une traversée de cloison étanche dudit boîtier cryostat est dimensionnée pour accueillir le connecteur reliant deux fils élémentaires supraconducteurs successifs.

Un autre circuit électrique câblé supraconducteur conforme à l'invention est défini à la revendication 16.

Dans un mode de réalisation possible, cet autre circuit électrique câblé supraconducteur comporte en outre un dispositif de gestion de fluides de refroidissement externe au boîtier cryostat, configuré pour recevoir le premier fluide de refroidissement sortant de la troisième ouverture, et pour injecter le deuxième liquide de refroidissement sous pression au travers de la quatrième ouverture.

### Brève description des figures

La description qui va suivre en regard des dessins annexés, donnés à titre d'exemples non limitatifs, fera bien comprendre en quoi consiste l'invention et comment elle peut être réalisée. Sur les figures annexées:
La figure 1 illustre schématiquement une vue (a) montrant un boîtier cryostat selon un premier mode de réalisation de l'invention, et une vue (b) montrant un exemple de circuit électrique câblé supraconducteur utilisant ce boitier cryostat;
La figure 2 est un grossissement d'une partie de la figure 1, montrant une traversée de cloison étanche conformément à l'invention;
La figure 3 illustre une variante de réalisation d'une pluralité de traversées étanches au sein d'une même cloison séparatrice ;
La figure 4 illustre schématiquement un autre exemple de circuit électrique câblé supraconducteur utilisant le boitier cryostat de la figure 1;
La figure 5 illustre schématiquement un exemple de circuit électrique câblé supraconducteur formant un boucle supraconductrice fermée et utilisant un boîtier cryostat selon un deuxième mode de réalisation conforme à l'invention.

### Description de mode(s) de réalisation

Dans les figures, les éléments identiques ou équivalents porteront les mêmes signes de référence. Les différents schémas ne sont pas à l'échelle.

Dans toute la description, on entend par fil supraconducteur (ou par fil élémentaire supraconducteur) tout élément longitudinal supraconducteur ou comportant un coeur longitudinal métallique (par exemple en cuivre) entouré d'au moins une couche supraconductrice (formée par exemple de plusieurs fils ou rubans supraconducteurs entourant le coeur de cuivre).

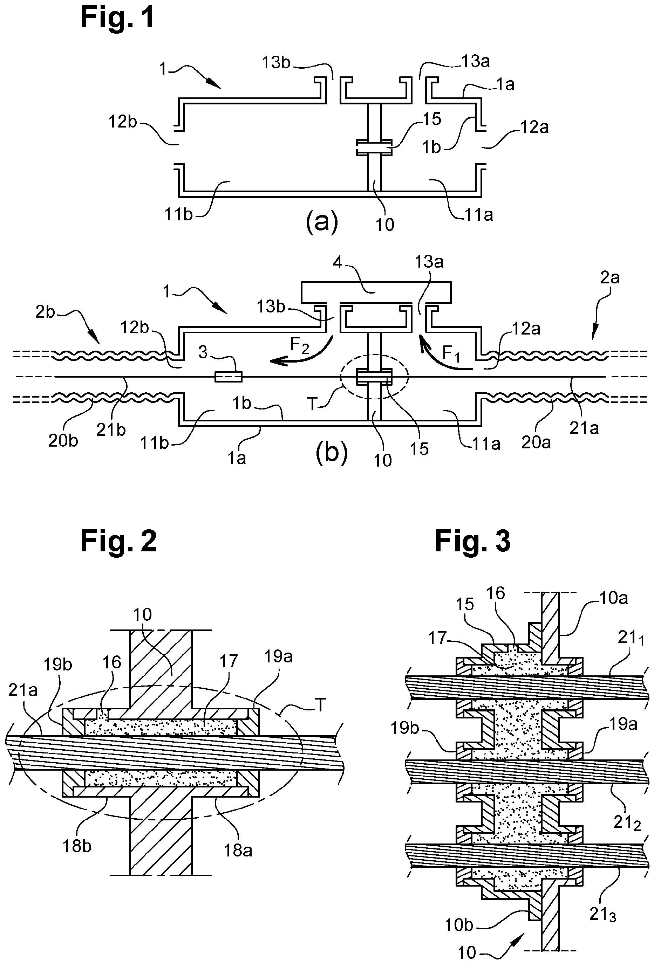

La figure 1 illustre schématiquement un premier mode de réalisation d'un boîtier cryostat 1 conforme à l'invention, particulièrement adapté aux circuits câblés supraconducteurs s'étendant entre deux points distants, et un exemple d'utilisation de ce boîtier cryostat. Plus précisément, la vue (a) de la figure 1 montre le boîtier cryostat 1 seul, avant utilisation dans un quelconque circuit, et la vue (b) illustre une portion d'un exemple de circuit câblé supraconducteur utilisant ce boîtier cryostat 1.

Comme visible sur cette figure 1, le boîtier cryostat 1, réalisé en tout matériau électriquement conducteur, de préférence en acier inoxydable, comporte une cloison séparatrice 10 délimitant un premier espace 11a et un deuxième espace 11b internes au boîtier cryostat 1. Le boîtier 1 comporte préférentiellement deux enveloppes concentriques 1a, 1b séparées par du vide.

Le boîtier cryostat 1 comporte en outre une première ouverture 12a et une deuxième ouverture 12b d'accès au boîtier cryostat, situées de part et d'autre de la cloison séparatrice 10, et débouchant respectivement sur le premier espace 11a interne et sur le deuxième espace 11b interne. Chacune de ces première et deuxième ouvertures 12a, 12b est configurée pour permettre la fixation étanche d'une extrémité d'une enveloppe cryogénique entourant au moins un fil supraconducteur et autoriser le passage dudit au moins un fil supraconducteur respectivement dans le premier espace interne 11a et dans le deuxième espace interne 11b. Ainsi, comme plus particulièrement visible sur la vue (b), un exemple de circuit câblé supraconducteur utilisant le boîtier cryostat 1 de la vue (a) comporte :
- un premier câble supraconducteur 2a comprenant une première enveloppe cryogénique 20a entourant au moins un premier fil supraconducteur 21a, et à l'intérieur de laquelle circule un premier fluide de refroidissement ;
- un deuxième câble supraconducteur 2b comprenant une deuxième enveloppe cryogénique 20b entourant au moins un deuxième fil supraconducteur 21b, et à l'intérieur de laquelle circule un deuxième fluide de refroidissement ;
le premier câble supraconducteur 2a et le deuxième câble supraconducteur 2b étant reliés au boitier cryostat 1 de façon à ce qu'une extrémité de la première enveloppe cryogénique 20a soit fixée de manière étanche, par tout moyen connu, à la première ouverture 12a du boîtier cryostat 1 et une extrémité de la deuxième enveloppe cryogénique 20b soit fixée de manière étanche, par tout moyen connu, à la deuxième ouverture 12b du boîtier cryostat 1. Comme on le voit sur la vue (b), les deux enveloppes concentriques formant les enveloppes cryogéniques 20a et 20b de chacun des deux câbles supraconducteurs 2a et 2b sont fixées aux deux enveloppes concentriques 1a et 1b formant le boîtier 1 au niveau des ouvertures 12a et 12b.

Le boîtier cryostat 1 comporte en outre une troisième ouverture 13a, communiquant avec le premier espace interne 11a. Cette troisième ouverture 13a est destinée à former une sortie pour un fluide de refroidissement circulant dans une enveloppe cryogénique fixée à la première ouverture 12a. Dans l'exemple de circuit schématisé sur la vue (b) de la figure 1, la troisième ouverture 13a forme une sortie pour le premier fluide de refroidissement circulant dans l'enveloppe cryogénique 20a du premier câble supraconducteur 2a et pénétrant dans le premier espace interne 11a, comme représenté par la flèche de circulation F₁.

Le boîtier cryostat 1 comporte en outre une quatrième ouverture 13b, communiquant avec le deuxième espace interne 11b. Cette quatrième ouverture 13b est destinée à former une entrée pour un fluide de refroidissement sous pression circulant dans une enveloppe cryogénique fixée à la deuxième ouverture 12b. Dans l'exemple de circuit montré sur la vue (b) de la figure 1, la quatrième ouverture 13b forme une entrée pour le deuxième fluide de refroidissement pénétrant dans le deuxième espace interne 11b puis circulant dans l'enveloppe cryogénique 20b du deuxième câble supraconducteur 2b, comme représenté par la flèche de circulation F₂.

La cloison séparatrice 10 étant prévue pour être traversée par au moins un fil supraconducteur traversant également la première ouverture 12a et/ou la deuxième ouverture 12b, tel que le fil supraconducteur 21a ou 21b du premier câble 2a ou du deuxième câble 2b, la cloison séparatrice 10 intègre, conformément à l'invention, une cavité 15 formant au moins une traversée de cloison étanche aux fluides de refroidissement pour autoriser le passage dudit au moins un fil supraconducteur. Dans l'exemple non limitatif de la vue (b), c'est le fil supraconducteur 21a du premier câble 2a qui traverse la cloison séparatrice 10 via la traversée de cloison étanche.

Pour ce faire, et comme plus particulièrement visible sur le schéma de la figure 2 qui représente un zoom T sur la vue (b) de la figure 1, la cloison séparatrice 10 intègre une ouverture 16 d'accès à la cavité 15, débouchant de préférence sur le premier espace interne 11a ou, comme illustré sur la figure 1, sur le deuxième espace interne 11b, pour permettre, après passage dudit au moins un fil supraconducteur 21a, 21b, le remplissage de la cavité 15 par injection d'un matériau isolant électrique 17 sous forme liquide polymérisable. La figure 2 illustre schématiquement la traversée de cloison rendue étanche après polymérisation du matériau isolant électrique 17 autour du fil supraconducteur 21a au travers de la paroi 10. Le matériau isolant électrique 17 est par exemple une résine epoxy bi-composant polymérisant à température ambiante, ou tout autre matériau isolant électrique polymérisant, de préférence à température ambiante, et supportant les températures cryogéniques.

Afin d'éviter que le fil supraconducteur traversant la cloison 10 ne soit en contact avec les parois de la traversée de cloison pendant l'opération d'injection du matériau isolant électrique 17 sous forme liquide, la traversée de cloison comporte deux extrémités 18a, 18b sensiblement cylindriques s'étendant transversalement de part et d'autre de la cloison séparatrice 10, chaque extrémité 18a, 18b étant équipée d'un anneau de centrage 19a, 19b en matériau électriquement isolant au travers duquel le fil supraconducteur, dans l'exemple le fil 21a, peut être enfilé avant l'opération d'injection. L'ouverture 16 d'accès peut être portée par l'une des extrémités, par exemple par l'extrémité 18b comme représenté sur la figure 2. Le matériau utilisé pour les anneaux de centrage 19a, 19b est choisi pour supporter les températures critiques des fluides de refroidissement. On peut opter par exemple pour de la fibre de verre epoxy G10 ou du tétra-fluoroéthylène. Pour améliorer encore l'étanchéité du système pendant l'opération d'injection du matériau isolant électrique sous forme liquide, deux manchons rétractables (non représentés) peuvent être avantageusement utilisés, chaque manchon rétractable formant un joint étanche entre chaque anneau de centrage 19a, 19b et le fil supraconducteur traversant la cloison.

Dans l'exemple non limitatif de circuit câblé schématisé sur la vue (b) de la figure 1 dans lequel le boîtier cryostat 1 relie deux câbles supraconducteurs distincts 2a et 2b comportant chacun leur propre enveloppe cryogénique 20a, respectivement 20b, entourant chacune au moins un fil supraconducteur 21a, respectivement 21b, le circuit câblé supraconducteur comporte en outre un connecteur 3 à l'intérieur du boîtier cryostat 1, ce connecteur 3 connectant électriquement en série le premier fil supraconducteur 21a et le deuxième fil supraconducteur 21b.

Dans l'exemple non limitatif correspondant à la vue (b), c'est le premier fil 21a du premier câble supraconducteur 2a qui traverse la cloison séparatrice 10, de sorte que le connecteur 3 est placé dans le deuxième espace interne 11b du boîtier cryostat 1. En première variante, on peut envisager que ce soit le fil supraconducteur 21b du deuxième câble supraconducteur 2b qui traverse la cloison séparatrice 10, auquel cas le connecteur 3 sera placé dans le premier espace interne 11a. Dans les deux cas, l'opération de connexion entre les deux fils supraconducteurs 21a et 21b ne peut être effectuée qu'après avoir enfilé le premier fil supraconducteur 21a ou le deuxième fil supraconducteur 21b au travers de la cloison séparatrice, mais indifféremment avant ou après l'opération d'injection du matériau sous forme liquide. En deuxième variante (non représentée), on peut prévoir que la traversée de cloison soit dimensionnée pour accueillir le connecteur 3 reliant en série les deux fils supraconducteurs 21a et 21b. Les mises en oeuvre consistant à placer le connecteur 3 dans le deuxième espace interne 11b, c'est-à-dire du côté où le deuxième fluide de refroidissement est injecté au travers de la quatrième ouverture 13b, sont néanmoins préférées car elles permettent de soumettre le connecteur 3, susceptible de générer des pertes résistives, à une température du fluide de refroidissement inférieure à la température critique et favorisant l'état supraconducteur.

Dans une variante de réalisation non représentée, particulièrement adaptée aux situations dans lesquelles les enveloppes cryogéniques fixées aux première et deuxième ouvertures 12a, 12b du boitier cryostat entourent, non pas un unique fil supraconducteur, mais une pluralité de fils supraconducteurs, la cloison séparatrice 10 intègre autant de cavités 15 formant chacune une traversée de cloison pour autoriser le passage d'un fil supraconducteur, et comportant chacune une ouverture d'accès 16. Il est ainsi possible de rendre chaque traversée de cloison étanche aux fluides de refroidissement en remplissant séparément chaque cavité avec le matériau isolant sous forme liquide.

La réalisation d'une pluralité de traversées de cloison chacune étanche aux fluides de refroidissement peut être également facilitée grâce à la variante de réalisation de la cloison séparatrice 10 du boîtier cryostat représentée en coupe sur la figure 3. Dans cet exemple non limitatif, la cloison séparatrice 10 est traversée par trois fils supraconducteurs 21₁, 21₂, 21₃, provenant par exemple d'un câble supraconducteur dont l'enveloppe cryogénique a été fixée sur la première ouverture 12a ou sur la deuxième ouverture 12b du boîtier cryostat. Ici, la cloison séparatrice 10 est formée non pas d'une unique paroi, mais de deux parois 10a, 10b fixées l'une à l'autre, et configurées pour définir une unique cavité 15 formant une pluralité de traversées de cloison (trois dans l'exemple) autorisant chacune le passage d'un des fils supraconducteurs 21₁, 21₂, 21₃. L'une des parois, ici la paroi 10b, comprend une ouverture d'accès 16 à la cavité, de préférence sur la partie supérieure de la paroi 10b. Après passage des fils supraconducteurs 21₁, 21₂, 21₃ dans leur traversée de cloison respective, le remplissage de l'unique cavité 15 par injection du matériau isolant électrique sous forme liquide polymérisable au travers de l'ouverture d'accès 16 permet de rendre simultanément chaque traversée de cloison étanche aux fluides de refroidissement. Des anneaux de centrage 19a, 19b, similaires aux anneaux décrits en référence à la figure 2, sont également utilisés aux deux extrémités cylindriques formant chaque traversée de cloison pour éviter que les fils supraconducteurs ne soient en contact avec les parois internes de leur traversée de cloison respective avant l'opération d'injection.

Dans la configuration montrée sur la vue (b) de la figure 1, avec une cloison séparatrice selon la figure 2 ou la figure 3, le boîtier cryostat permet d'effectuer à la fois la jonction électrique de deux câbles supraconducteurs 2a, 2b comprenant chacun un ou plusieurs fils supraconducteurs grâce à la présence d'une ou plusieurs traversées de cloison, et d'autoriser un gestion efficace de la circulation des fluides de refroidissement grâce au fait que la traversée de cloison soit rendue étanche aux fluides de refroidissement.

Le circuit peut ainsi comporter tout dispositif 4 de gestion des fluides de refroidissement externe au boîtier cryostat 1, configuré pour recevoir le premier fluide de refroidissement sortant de la troisième ouverture 13a, et pour injecter le deuxième liquide de refroidissement sous pression et à une température plus basse que la température critique associée au deuxième fil supraconducteur 21b au travers de la quatrième ouverture 13b. Dans une implémentation possible, le dispositif 4 peut par exemple récupérer, via la troisième ouverture 13a du boîtier, le premier fluide de refroidissement provenant du premier câble 2a, dont la température s'est élevée au fur et à mesure de sa course dans le câble supraconducteur 2a, puis le réinjecter sous forme du deuxième fluide de refroidissement, après avoir adapté la pression et la température nécessaires respectivement à la bonne circulation du fluide dans le deuxième câble 2b et au bon refroidissement du fil supraconducteur 1b. En variante, le premier fluide et le deuxième fluide de refroidissement sont de nature différente. On peut en particulier prévoir de réaliser une ligne câblée de très grande longueur, en reliant une succession de câbles supraconducteurs de telle sorte que deux câbles se succédant dans la ligne soient reliés au moyen d'un boitier cryostat et d'un système de gestion des fluides conformes à l'invention.

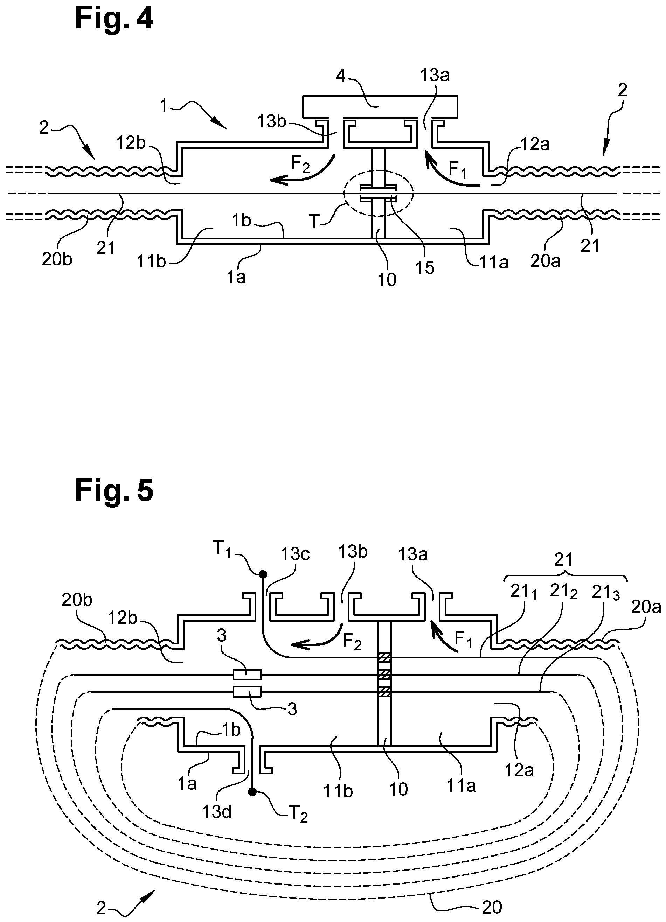

Dans la représentation schématique donnée sur la vue (b) de la figure 1, on a considéré que le boîtier cryostat 1 servait à relier deux câbles distincts 2a, 2b. Un autre exemple d'utilisation du boîtier cryostat 1 de la figure 1(a) est illustré schématiquement sur la figure 4. Cet exemple de circuit électrique câblé supraconducteur ne diffère du premier exemple illustré schématiquement sur la figure 1(b) que par le fait qu'il utilise un seul câble supraconducteur 2 comprenant un fil supraconducteur 21 entouré par une enveloppe cryogénique. Les références 20a et 20b sur la figure 4 illustrent ici deux portions de l'enveloppe cryogénique fixées de manière étanche aux ouvertures 12a, respectivement 12b, du boîtier cryostat 1. Comme visible sur la figure 4, le fil supraconducteur 21 traverse la cloison séparatrice 10 via la traversée de cloison rendue étanche, comme expliqué ci-avant, par injection du matériau isolant électrique sous forme liquide dans la cavité 15. Ici encore, un premier fluide de refroidissement circulant dans la portion 20a de l'enveloppe cryogénique va pénétrer dans le boîtier cryostat par la première ouverture 12a du boîtier cryostat 1 puis sortir par la troisième ouverture 13a du boîtier cryostat 1 (flèche F₁), et un deuxième fluide de refroidissement sous pression va pouvoir entrer par la quatrième ouverture 13b du boîtier cryostat 1 et circuler dans la portion 20b de l'enveloppe cryogénique par l'intermédiaire de la deuxième ouverture 12b (Flèche F₂). Comme dans l'exemple précédent, un dispositif 4 de gestion de fluides de refroidissement externe au boîtier cryostat 1 reçoit le premier fluide de refroidissement sortant de la troisième ouverture 13a, et dont la température s'est élevée au fur et à mesure de sa course dans la portion 20a de l'enveloppe cryogénique, et injecte le deuxième liquide de refroidissement sous pression et à une température plus basse que la température critique du fil supraconducteur 21au travers de la quatrième ouverture 13b. Comme précédemment, le deuxième liquide de refroidissement peut être le premier liquide de refroidissement dont la température a été abaissée par rapport à la température atteinte par le premier liquide de refroidissement lorsqu'il sort de la troisième ouverture 13a, pour qu'il atteigne de nouveau une température inférieure à la température critique. En variante, le premier fluide et le deuxième fluide de refroidissement peuvent être de nature différente.

Dans une variante de réalisation non représentée du circuit de la figure 4, le câble supraconducteur 2 peut comporter plusieurs fils supraconducteurs passant au travers de la même traversée de cloison étanche aux fluides de refroidissement. Dans une autre variante de réalisation non représentée du circuit de la figure 4, le câble supraconducteur 2 peut comporter plusieurs fils supraconducteurs passant chacun dans une traversée de cloison étanche de la cloison séparatrice du boîtier cryostat, chaque traversée étant obtenue selon les principes explicités ci-dessus en référence à la figure 2 ou à la figure 3.

Un autre exemple de circuit supraconducteur câblé utilisant un boîtier cryostat selon un deuxième mode de réalisation conforme à l'invention va à présent être décrit en référence à la figure 5. Le circuit électrique câblé supraconducteur réalise ici une boucle électrique supraconductrice fermée et comporte un câble supraconducteur 2 comprenant un fil supraconducteur 21 enroulé sur plusieurs tours (trois tours dans l'exemple non limitatif de la figure 5) et une enveloppe cryogénique 20 unique à l'intérieur de laquelle passent côte à côte lesdits tours, isolés électriquement les uns des autres. Le fil supraconducteur 21 est de préférence composé d'une succession de fils élémentaires supraconducteurs connectés en série, chaque fil élémentaire formant un tour de l'enroulement. Dans l'exemple de la figure 5, trois fils élémentaires supraconducteurs 21₁, 21₂ et 21₃ sont illustrés et forment chacun un tour de l'enroulement.

Le boîtier cryostat 1 selon le deuxième mode de réalisation est très similaire au boîtier cryostat de la vue (a) de la figure 1, en ce qu'il comporte :
- deux enveloppes concentriques 1a, 1b séparées par du vide ;
- une cloison séparatrice 10 délimitant un premier espace 11a et un deuxième espace 11b internes au boîtier cryostat 1 ;
- une première ouverture 12a et une deuxième ouverture 12b du boîtier cryostat 1 situées de part et d'autre de la cloison séparatrice 10, débouchant respectivement sur le premier espace 11a interne et sur le deuxième espace 11b interne;
- une troisième ouverture 13a communiquant avec le premier espace interne 11a et destinée à former une sortie pour un fluide de refroidissement; et
- une quatrième ouverture 13bcommuniquant avec le deuxième espace interne 11b et destinée à former une entrée pour un fluide de refroidissement.

La cloison séparatrice 10 intègre autant de traversées de cloison qu'il y a de tours dans l'enroulement. Dans l'exemple de la figure 5, trois traversées de cloison sont schématisées et permettent le passage de chaque fil élémentaire supraconducteur 21₁, 21₂ et 21₃. Ces traversées de cloisons sont rendues étanches aux fluides de refroidissement de la même façon que dans le cas de la traversée de cloison décrite sur la figure 2. En variante, ces traversées sont formées par une cavité unique, dont le remplissage par un matériau électrique isolant injecté sous forme liquide polymérisable permet l'obtention simultanée de trois traversées étanches, comme expliqué en référence à la figure 3.

Pour ce circuit formant une boucle fermée, le boîtier cryostat 1 est ainsi relié au câble 2 supraconducteur de façon à ce que :
- une première extrémité 20a de l'enveloppe cryogénique 20 unique est fixée de manière étanche à la première ouverture 12a du boîtier cryostat 1, les deux enveloppes concentriques formant la première extrémité 20a de l'enveloppe cryogénique 20 du câble supraconducteur 2 étant fixées par exemple aux deux enveloppes concentriques 1a et 1b formant le boîtier 1 au niveau de la première ouverture 12a ;
- une deuxième extrémité 20b de l'enveloppe cryogénique 20 unique est fixée de manière étanche à la deuxième ouverture 12b du boîtier cryostat 1, les deux enveloppes concentriques formant la deuxième extrémité 20b de l'enveloppe cryogénique 20 du câble supraconducteur 2 étant fixées par exemple aux deux enveloppes concentriques 1a et 1b formant le boîtier 1 au niveau de la deuxième ouverture 12b;
- chaque tour du fil supra conducteur passe au travers d'une traversée distincte parmi les trois traversées de cloison étanches de la cloison séparatrice 10;
- un fluide de refroidissement sous pression entre par la quatrième ouverture 13b du boîtier cryostat 1 (flèche F₂) et circule dans l'enveloppe cryogénique 20 unique;
- le fluide de refroidissement ressort par la troisième ouverture 13a du boîtier cryostat (flèche F₁).

Le boîtier cryostat 1 représenté sur la figure 5 comporte également :
- une cinquième ouverture 13c pour permettre l'injection, à partir d'une terminaison électrique d'entrée T₁ du circuit électrique, externe au boîtier cryostat, d'un courant électrique sur une première extrémité du fil supraconducteur 21.
- une sixième ouverture 13d pour permettre de récupérer un courant électrique à une deuxième extrémité du fil supraconducteur sur une terminaison électrique de sortie T₂ du circuit électrique, externe au boîtier cryostat.

En variante non représentée, le boîtier ne comporte pas de sixième ouverture. Dans ce cas, la terminaison électrique de sortie T₂ du circuit électrique est située à proximité de terminaison électrique d'entrée T₁ et de la cinquième ouverture 13c, cette dernière permettant d'injecter le courant sur une extrémité du fil 21 (ici sur l'extrémité libre du fil élémentaire 21₁ formant le premier tour de l'enroulement), et de récupérer le courant sur l'autre extrémité du fil 21 (ici sur l'extrémité libre du fil élémentaire 21₃ formant le troisième et dernier tour de l'enroulement).

Comme le fil 21 est constitué ici d'une succession de fils élémentaires, deux fils élémentaires supraconducteurs successifs sont reliés en série par un connecteur 3. La figure 5 montre ainsi deux connecteurs 3, l'un pour connecter le premier fil élémentaire 21₁ et le deuxième fil élémentaire 21₂, l'autre pour connecter le deuxième fil élémentaire 21₂ et le troisième fil élémentaire 21₃.

Bien entendu, les connecteurs ne sont pas nécessaires dans le cas où le fil supraconducteur 21 est prévu suffisamment long pour être enroulé sur le nombre voulu de tours.

Les connecteurs 3 sont placés avantageusement à l'intérieur du boîtier cryostat 1, de préférence du côté de l'espace interne 11b dans lequel le fluide de refroidissement est injecté. En variante non représentée, au moins une traversée de cloison étanche dudit boîtier cryostat est dimensionnée pour accueillir le connecteur reliant deux fils élémentaires supraconducteurs successifs.

Dans la configuration montrée sur la figure 5, le boîtier cryostat constitue avantageusement un boîtier de connexion qui permet à la fois :
- d'effectuer la jonction électrique des différents fils élémentaires supraconducteurs formant les différents tours de l'enroulement ;
- de faire circuler un courant le long des fils élémentaires grâce aux ouvertures 13b/13c permettant les connexions aux terminaison d'entrée T₁ et de sortie T₂ ;
- et d'autoriser la circulation d'un fluide de refroidissement à l'intérieur de la boucle fermée, rendue possible par la présence d'une cloison séparatrice étanche au fluide de refroidissement entre l'ouverture 13a et l'ouverture 13b.

## Revendications

1. Boîtier cryostat (1) pour circuit câblé supraconducteur, ledit boîtier cryostat (1) comportant :
• une cloison séparatrice (10) délimitant un premier espace (11a) et un deuxième espace (11b) internes au boîtier cryostat (1) ;
• une première ouverture (12a) et une deuxième ouverture (12b) du boîtier cryostat (1) situées de part et d'autre de la cloison séparatrice, débouchant respectivement sur le premier espace (11a) interne et sur le deuxième espace (11b) interne et configurées chacune pour fixer de manière étanche une extrémité d'une enveloppe cryogénique (20a, 20b ;20) entourant au moins un fil supraconducteur (21a, 21b ; 21) et pour permettre le passage d'au moins un fil supraconducteur (21a, 21b ; 21) respectivement dans le premier espace interne (11a) et dans le deuxième espace interne (11b) ;
• une troisième ouverture (13a) du boîtier cryostat (1), communiquant avec le premier espace interne (11a) et formant une sortie pour un fluide de refroidissement circulant dans une enveloppe cryogénique (20a ; 20) fixée à la première ouverture (12a) ;
• une quatrième ouverture (13b) du boîtier cryostat (1), communiquant avec le deuxième espace interne (11b) et formant une entrée pour un fluide de refroidissement sous pression circulant dans une enveloppe cryogénique (20b ; 20) fixée à la deuxième ouverture (12b) ;
le boîtier cryostat (1) étant **caractérisé en ce que** ladite cloison séparatrice (10) intègre une cavité (15) formant au moins une traversée de cloison pour permettre le passage d'au moins un fil supraconducteur (21a, 21b ; 21), et une ouverture (16) d'accès à ladite cavité (15) permettant le remplissage de ladite cavité (15) par un matériau isolant électrique injecté sous forme liquide polymérisable afin de rendre ladite au moins une traversée de cloison étanche aux fluides de refroidissement après polymérisation du matériau isolant électrique.

2. Boîtier cryostat (1) selon la revendication 1, **caractérisé en ce que** ladite cloison séparatrice (10) intègre une pluralité de cavités (15) formant chacune une traversée de cloison pour permettre le passage d'un fil d'une pluralité de fils supraconducteurs, et une ouverture d'accès (16) par cavité (15), pour permettre un remplissage séparé de chaque cavité est par le matériau isolant électrique injecté sous forme liquide.

3. Boîtier cryostat (1) selon la revendication 1, **caractérisé en ce que** ladite cloison séparatrice (10) intègre une unique cavité (15) formant une pluralité de traversées de cloison pour permettre le passage d'un fil d'une pluralité de fils supraconducteurs (21₁, 21₂, 21₃), le remplissage de l'unique cavité (15) par injection du matériau isolant électrique sous forme liquide polymérisable permettant de rendre chaque traversée de cloison étanche aux fluides de refroidissement après polymérisation du matériau isolant électrique.

4. Boîtier cryostat (1) selon l'une quelconque des revendications 2 ou 3, **caractérisé en ce qu'**il comporte au moins une cinquième ouverture (13c) pour permettre l'injection, à partir d'une terminaison électrique d'entrée (T₁) externe au boîtier cryostat, d'un courant électrique sur une première extrémité d'un fil supraconducteur (21) traversant la cloison séparatrice (10).

5. Boîtier cryostat (1) selon la revendication 4, **caractérisé en ce que** la cinquième ouverture (13c) permet en outre de récupérer un courant électrique à une deuxième extrémité du fil supraconducteur (21) sur une terminaison électrique de sortie (T₁) externe au boîtier cryostat.

6. Boîtier cryostat (1) selon la revendication 4, **caractérisé en ce qu'**il comporte une sixième ouverture (13d) pour permettre de récupérer un courant électrique à une deuxième extrémité du fil supraconducteur (21) sur une terminaison électrique de sortie (T₂) externe au boîtier cryostat.

7. Boîtier cryostat (1) selon l'une quelconque des revendications précédentes, **caractérisé en ce que** ladite au moins une traversée de cloison étanche est dimensionnée pour accueillir un connecteur (3) reliant en série deux fils élémentaires supra conducteur composant ledit au moins un fil supraconducteur.

8. Boîtier cryostat selon l'une quelconque des revendications précédentes, **caractérisé en ce que** ladite au moins une traversée de cloison comporte deux extrémités (18a, 18b) sensiblement cylindriques s'étendant transversalement de part et d'autre de la cloison séparatrice (10), chaque extrémité (18a, 18b) étant équipée d'un anneau de centrage (19a, 19b) en matériau électriquement isolant.

9. Circuit électrique câblé supraconducteur comportant :
• un premier câble (2a) supraconducteur comprenant une première enveloppe cryogénique (20a) entourant au moins un premier fil supraconducteur (21a) et à l'intérieur de laquelle circule un premier fluide de refroidissement ;
• un deuxième câble (2b) supraconducteur comprenant une deuxième enveloppe cryogénique (20b) entourant au moins un deuxième fil supraconducteur (21b) et à l'intérieur de laquelle circule un deuxième fluide de refroidissement ;
• un boîtier cryostat (1) selon la revendication 1, reliant le premier câble (2a) supraconducteur et le deuxième câble (2b) supraconducteur de façon à ce que :
- une extrémité de la première enveloppe cryogénique (20a) est fixée de manière étanche à la première ouverture (12a) du boîtier cryostat (1);
- une extrémité de la deuxième enveloppe cryogénique (20b) est fixée de manière étanche à la deuxième ouverture (12b) du boîtier cryostat (1);
- le premier fluide de refroidissement sort par la troisième ouverture (13a) du boîtier cryostat (1);
- le deuxième fluide de refroidissement entre par la quatrième ouverture (13b) du boîtier cryostat (1) ; et
- ledit au moins un premier fil supraconducteur (21a) et/ou ledit au moins un deuxième fil supraconducteur (21b) passe au travers de ladite au moins une traversée de cloison et est entouré d'un matériau isolant électrique polymérisé rendant la traversée de cloison étanche; et
• au moins un connecteur (3) à l'intérieur du boîtier cryostat (1) connectant électriquement en série ledit au moins un premier fil supraconducteur (21a) et ledit au moins un deuxième fil supraconducteur (21b).

10. Circuit électrique câblé supraconducteur selon la revendication 9, dans lequel ledit au moins un connecteur (3) est placé dans le premier espace interne (11a) ou dans le deuxième espace interne (11b) du boîtier cryostat (1).

11. Circuit électrique câblé supraconducteur selon la revendication 9, dans lequel ledit au moins un connecteur (3) est placé dans ladite au moins une traversée de cloison étanche.

12. Circuit électrique câblé supraconducteur selon l'une quelconque des revendications 9 à 11, **caractérisé en ce qu'**il comporte en outre un dispositif (4) de gestion de fluides de refroidissement externe au boîtier cryostat (1), configuré pour recevoir le premier fluide de refroidissement sortant de la troisième ouverture (13a), et pour injecter le deuxième liquide de refroidissement sous pression au travers de la quatrième ouverture (13b).

13. Circuit électrique câblé supraconducteur formant une boucle électrique supraconductrice fermée comportant:
• un câble (2) supraconducteur comprenant un fil supraconducteur (21) enroulé sur plusieurs tours et une enveloppe cryogénique (20) unique à l'intérieur de laquelle passent côte à côte lesdits tours;
• un boîtier cryostat (1) selon l'une quelconque des revendications 5 ou 6, relié audit câble (2) supraconducteur de sorte que :
- une première extrémité (20a) de l'enveloppe cryogénique (20) unique est fixée de manière étanche à la première ouverture (12a) du boîtier cryostat (1);
- une deuxième extrémité (20b) de l'enveloppe cryogénique (20) unique est fixée de manière étanche à la deuxième ouverture (12b) du boîtier cryostat (1);
- chaque tour du fil supra conducteur passe au travers d'une traversée distincte parmi la pluralité de traversées de cloison de la cloison séparatrice (10) dudit boîtier cryostat (1), et est entouré d'un matériau isolant électrique polymérisé rendant chaque traversée de cloison étanche ;
- un fluide de refroidissement sous pression entre par la quatrième ouverture (13b) du boîtier cryostat (1) et circule dans l'enveloppe cryogénique (20) unique;
- ledit fluide de refroidissement sort par la troisième ouverture (13a) du boîtier cryostat (1) ;
• une terminaison électrique d'entrée (T₁) reliée à une première extrémité du fil supraconducteur (21) au travers de la cinquième ouverture (13c) du boîtier cryostat (1) pour l'injection d'un courant électrique sur ledit fil supraconducteur (21) ; et
• une terminaison électrique de sortie (T₂) reliée à une deuxième extrémité du fil supraconducteur (21) au travers de la cinquième ouverture (13c) ou de la sixième ouverture (13d) du boîtier cryostat (1) pour la récupération du courant électrique circulant dans le fil supraconducteur (21).

14. Circuit électrique câblé supraconducteur selon la revendication 13, dans lequel chaque tour dudit fil supraconducteur est constitué d'un fil élémentaire supraconducteur (21₁, 21₂, 21₃), deux fils élémentaires supraconducteurs successifs étant reliés en série par un connecteur (3) placé à l'intérieur du boîtier cryostat (1).

15. Circuit électrique câblé supraconducteur selon la revendication 14, dans lequel au moins une traversée de cloison étanche dudit boîtier cryostat (1) est dimensionnée pour accueillir le connecteur (3) reliant deux fils élémentaires supraconducteurs successifs.

16. Circuit électrique câblé supraconducteur comportant :
• un câble supraconducteur comprenant une enveloppe cryogénique (20a, 20b) entourant au moins un fil supraconducteur et à l'intérieur de laquelle circule un premier fluide de refroidissement ;
• un boîtier cryostat (1) selon la revendication 1, relié audit câble supraconducteur de sorte que :
- l'enveloppe cryogénique (20a, 20b) est fixée de manière étanche d'une part, à la première ouverture (12a) et d'autre part, à la deuxième ouverture du boîtier cryostat (12b);
- ledit au moins un fil supraconducteur passe au travers de ladite au moins une traversée (15) de cloison et est entouré d'un matériau isolant électrique polymérisé rendant ladite traversée de cloison étanche;
- un premier fluide de refroidissement circulant dans l'enveloppe cryogénique (20a, 20b) et pénétrant dans le boîtier cryostat (1) par la première ouverture (12a) sort par la troisième ouverture (13a) du boîtier cryostat (1);
- un deuxième fluide de refroidissement sous pression entre par la quatrième ouverture (13b) du boîtier cryostat (1) et circule dans l'enveloppe cryogénique (20a, 20b) par l'intermédiaire de la deuxième ouverture (12b).

17. Circuit électrique câblé supraconducteur selon la revendication 16, **caractérisé en ce qu'**il comporte en outre un dispositif (4) de gestion de fluides de refroidissement externe au boîtier cryostat (1), configuré pour recevoir le premier fluide de refroidissement sortant de la troisième ouverture (13a), et pour injecter le deuxième liquide de refroidissement sous pression au travers de la quatrième ouverture (13b).

## Patentansprüche

1. Kryostatgehäuse (1) für supraleitende verdrahtete Schaltung, das Kryostatgehäuse (1) umfassend:
• eine Trennwand (10), die einen ersten Raum (11a) und einen zweiten Raum (11b) innerhalb des Kryostatgehäuses (1) begrenzt;
• eine erste Öffnung (12a) und eine zweite Öffnung (12b) des Kryostatgehäuses (1), die sich auf beiden Seiten der Trennwand befinden, jeweils in den ersten Innenraum (11a) und in den zweiten Innenraum (11b) münden und jeweils konfiguriert sind, um ein Ende einer kryogenen Hülle (20a, 20b; 20), die mindestens einen supraleitenden Draht (21a, 21b; 21) zu umgeben, und um den Durchgang von jeweils mindestens einem supraleitenden Draht (21a, 21b; 21) in den ersten Innenraum (11a) bzw. in den zweiten Innenraum (11b) zu ermöglichen;
• eine dritte Öffnung (13a) des Kryostatgehäuses (1), die mit dem ersten Innenraum (11a) in Verbindung ist und einen Ausgang für ein Kühlfluid bildet, das in einer kryogenen Hülle (20a; 20) zirkuliert, die an der ersten Öffnung (12a) befestigt ist;
• eine vierte Öffnung (13b) des Kryostatgehäuses (1), die mit dem zweiten Innenraum (11b) in Verbindung ist und einen Eingang für ein unter Druck stehendes Kühlfluid bildet, das in einer kryogenen Hülle (20a; 20) zirkuliert, die an der zweiten Öffnung (12b) befestigt ist;
wobei das Kryostatgehäuse (1) **dadurch gekennzeichnet ist, dass** die Trennwand (10) einen Hohlraum (15), der mindestens eine Trennwanddurchführung bildet, um den Durchgang von mindestens einem supraleitenden Draht (21a, 21b; 21) zu ermöglichen, und eine Zugangsöffnung (16) zu dem Hohlraum (15), die das Füllen des Hohlraums (15) mit einem elektrisch isolierenden Material ermöglicht, das in flüssiger, polymerisierbarer Form eingespritzt wird, um die mindestens eine Trennwanddurchführung nach Polymerisation des elektrisch isolierenden Materials gegenüber den Kühlfluiden abzudichten, integriert.

2. Kryostatgehäuse (1) nach Anspruch 1, **dadurch gekennzeichnet, dass** die Trennwand (10) eine Vielzahl von Hohlräumen (15) integriert, die jeweils eine Trennwanddurchführung bilden, um den Durchgang eines Drahts aus einer Vielzahl von supraleitenden Drähten zu ermöglichen, und eine Zugangsöffnung (16) pro Hohlraum (15), um ein separates Füllen jedes östlichen Hohlraums mit dem in flüssiger Form eingespritzten elektrisch isolierenden Material zu ermöglichen.

3. Kryostatgehäuse (1) nach Anspruch 1, **dadurch gekennzeichnet, dass** die Trennwand (10) einen einzelnen Hohlraum (15) integriert, der eine Vielzahl von Trennwanddurchführungen bildet, um den Durchgang eines Drahts aus einer Vielzahl von supraleitenden Drähten (21₁, 21₂. 21₃) zu ermöglichen, das Füllen des einzelnen Hohlraums (15) durch Einspritzen des elektrisch isolierenden Materials in flüssiger, polymerisierbarer Form es ermöglicht, jede Trennwanddurchführung nach Polymerisation des elektrisch isolierenden Materials gegenüber den Kühlfluiden abzudichten.

4. Kryostatgehäuse (1) nach einem der Ansprüche 2 oder 3, **dadurch gekennzeichnet, dass** es mindestens eine fünfte Öffnung (13c) aufweist, um ausgehend von einem elektrischen Eingangsanschluss (T₁) außerhalb des Kryostatgehäuses das Einspeisen eines elektrischen Stroms an einem ersten Ende eines supraleitenden Drahts (21), der die Trennwand (10) durchquert, zu ermöglichen.

5. Kryostatgehäuse (1) nach Anspruch 4, **dadurch gekennzeichnet, dass** die fünfte Öffnung (13c) ferner ein Rückgewinnen eines elektrischen Stroms an einem zweiten Ende des supraleitenden Drahts (21) an einem elektrischen Ausgangsanschluss (T₁) außerhalb des Kryostatgehäuses ermöglicht.

6. Kryostatgehäuse (1) nach Anspruch 4, **dadurch gekennzeichnet, dass** es eine sechste Öffnung (13d) umfasst, um ein Rückgewinnen eines elektrischen Stroms an einem zweiten Ende des supraleitenden Drahts (21) an einem elektrischen Ausgangsanschluss (T₂) außerhalb des Kryostatgehäuses zu ermöglichen.

7. Kryostatgehäuse (1) nach einem der vorherigen Ansprüche, **dadurch gekennzeichnet, dass** die mindestens eine dichte Wanddurchführung bemessen ist, um einen Verbinder (3) aufzunehmen, der zwei supraleitende Elementardrähte, die den mindestens einen supraleitenden Draht bilden, in Reihe verbindet.

8. Kryostatgehäuse nach einem der vorherigen Ansprüche, **dadurch gekennzeichnet, dass** die mindestens eine Trennwanddurchführung zwei im Wesentlichen zylindrische Enden (18a, 18b) umfasst, die sich quer zu beiden Seiten der Trennwand (10) erstrecken, wobei jedes Ende (18a, 18b) mit einem Zentrierring (19a, 19b) aus elektrisch isolierendem Material ausgestattet ist.

9. Supraleitende verdrahtete elektrische Schaltung, umfassend:
• ein erstes supraleitendes Kabel (2a), umfassend eine erste kryogene Hülle (20a), die mindestens einen ersten supraleitenden Draht (21a) umgibt und in deren Innerem ein erstes Kühlfluid zirkuliert;
• ein zweites supraleitendes Kabel (2b) umfassend eine zweite kryogene Hülle (20b), die mindestens einen zweiten supraleitenden Draht (21b) umgibt und in deren Innerem ein zweites Kühlfluid zirkuliert;
• ein Kryostatgehäuse (1) nach Anspruch 1, das das erste supraleitende Kabel (2a) und das zweite supraleitende Kabel (2b) verbindet, sodass:
- ein Ende der ersten kryogenen Hülle (20a) dicht an der ersten Öffnung (12a) des Kryostatgehäuses (1) befestigt ist;
- ein Ende der zweiten kryogenen Hülle (20b) dicht an der zweiten Öffnung (12b) des Kryostatgehäuses (1) befestigt ist;
- das erste Kühlfluid durch die dritte Öffnung (13a) des Kryostatgehäuses (1) austritt;
- das zweite Kühlfluid durch die vierte Öffnung (13b) des Kryostatgehäuses (1) eintritt; und
- der mindestens eine erste supraleitende Draht (21a) und/oder der mindestens eine zweite supraleitende Draht (21b) durch die mindestens eine Trennwanddurchführung verläuft und von einem polymerisierten elektrisch isolierenden Material umgeben ist, das die Trennwanddurchführung abdichtet; und
• mindestens einen Verbinder (3) im Inneren des Kryostatgehäuses (1), der den mindestens einen ersten supraleitenden Draht (21a) und den mindestens einen zweiten supraleitenden Draht (21b) elektrisch in Reihe verbindet.

10. Supraleitende verdrahtete elektrische Schaltung nach Anspruch 9, wobei der mindestens eine Verbinder (3) in dem ersten Innenraum (11a) oder in dem zweiten Innenraum (11b) des Kryostatgehäuses (1) angeordnet ist.

11. Supraleitende verdrahtete elektrische Schaltung nach Anspruch 9, wobei der mindestens eine Verbinder (3) in der mindestens einen dichten Trennwanddurchführung platziert ist.

12. Supraleitende verdrahtete elektrische Schaltung nach einem der Ansprüche 9 bis 11, **dadurch gekennzeichnet**, **dadurch gekennzeichnet, dass** sie ferner eine Vorrichtung (4) zur Verwaltung von Kühlfluiden außerhalb des Kryostatgehäuses (1) umfasst, die konfiguriert ist, um das erste Kühlfluid, das aus der dritten Öffnung (13a) austritt, aufzunehmen und das zweite Kühlfluid unter Druck durch die vierte Öffnung (13b) einzuspritzen.

13. Supraleitende verdrahtete elektrische Schaltung, die eine geschlossene supraleitende elektrische Schleife bildet, umfassend:
• ein supraleitendes Kabel (2), umfassend einen supraleitenden Draht (21), der über mehrere Windungen gewickelt ist, und eine einzelne kryogenen Hülle (20), in der die Windungen Seite an Seite verlaufen;
• ein Kryostatgehäuse (1) nach einem der Ansprüche 5 oder 6, das mit dem supraleitenden Kabel (2) verbunden ist, sodass:
- ein erstes Ende (20a) der einzelnen kryogenen Hülle (20) dicht an der ersten Öffnung (12a) des Kryostatgehäuses (1) befestigt ist;
- ein zweites Ende (20b) der einzelnen kryogenen Hülle (20) dicht an der zweiten Öffnung (12b) des Kryostatgehäuses (1) befestigt ist;
- jede Windung des supraleitenden Drahts durch eine andere der Vielzahl von Trennwanddurchführungen der Trennwand (10) des Kryostatgehäuses (1) verläuft und von einem polymerisierten elektrisch isolierenden Material umgeben ist, das jede Trennwanddurchführung abdichtet;
- ein unter Druck stehendes Kühlfluid durch die vierte Öffnung (13b) des Kryostatgehäuses (1) eintritt und in der einzelnen kryogenen Hülle (20) zirkuliert;
- das Kühlfluid durch die dritte Öffnung (13a) des Kryostatgehäuses (1) austritt;
• einen elektrischen Eingangsanschluss (T₁), der durch die fünfte Öffnung (13c) des Kryostatgehäuses (1) mit einem ersten Ende des supraleitenden Drahts (21) verbunden ist, um einen elektrischen Strom auf den supraleitenden Draht (21) einzuspeisen; und
• einen elektrischen Ausgangsabschluss (T₂), der durch die fünfte Öffnung (13c) oder die sechste Öffnung (13d) des Kryostatgehäuses (1) mit einem zweiten Ende des supraleitenden Drahts (21) verbunden ist, um den elektrischen Strom, der durch den supraleitenden Draht (21) zirkuliert, zurückzugewinnen.

14. Supraleitende verdrahtete elektrische Schaltung nach Anspruch 13, wobei jede Windung des supraleitenden Drahts aus einem supraleitenden Elementardraht (21₁, 21₂, 21₃) besteht, wobei zwei aufeinanderfolgende supraleitende Elementardrähte durch einen Verbinder (3), der im Inneren des Kryostatgehäuses (1) platziert ist, in Reihe verbunden sind.

15. Supraleitende verdrahtete elektrische Schaltung nach Anspruch 14, wobei mindestens eine dichte Trennwanddurchführung des Kryostatgehäuses (1) bemessen ist, um den Verbinder (3) aufzunehmen, der zwei aufeinanderfolgende supraleitende Elementardrähte verbindet.

16. Supraleitende verdrahtete elektrische Schaltung, umfassend:
• ein supraleitendes Kabel, umfassend eine kryogene Hülle (20a, 20b), die mindestens einen supraleitenden Draht umgibt und in deren Innerem ein erstes Kühlfluid zirkuliert;
• ein Kryostatgehäuse (1) nach Anspruch 1, das mit dem supraleitenden Kabel verbunden ist, sodass:
- die kryogene Hülle (20a, 20b) einerseits an der ersten Öffnung (12a) und andererseits an der zweiten Öffnung des Kryostatgehäuses (12b) dicht befestigt ist;
- der mindestens eine supraleitende Draht durch die mindestens eine Trennwanddurchführung (15) verläuft und von einem polymerisierten elektrisch isolierenden Material umgeben ist, das die Trennwanddurchführung abdichtet;
- ein erstes Kühlmittel, das in der kryogenen Hülle (20a, 20b) zirkuliert und durch die erste Öffnung (12a) in das Kryostatgehäuse (1) eindringt, aus der dritten Öffnung (13a) des Kryostatgehäuses (1) austritt;
- ein zweites unter Druck stehendes Kühlfluid durch die vierte Öffnung (13b) des Kryostatgehäuses (1) eintritt und durch die zweite Öffnung (12b) in die kryogene Hülle (20a, 20b) zirkuliert.

17. Supraleitende verdrahtete elektrische Schaltung nach Anspruch 16, **dadurch gekennzeichnet, dass** sie ferner eine Vorrichtung (4) zur Verwaltung von Kühlfluiden außerhalb des Kryostatgehäuses (1) umfasst, die konfiguriert ist, um das erste Kühlfluid, das aus der dritten Öffnung (13a) austritt, aufzunehmen und das zweite Kühlfluid unter Druck durch die vierte Öffnung (13b) einzuspritzen.

## Claims

1. A cryostat housing (1) for a superconducting wired circuit, said cryostat housing (1) including:
• a partition wall (10) delimiting a first space (11a) and a second space (11b) internal to the cryostat housing (1);
• a first opening (12a) and a second opening (12b) of the cryostat housing (1) are located at one side and the other of the partition, opening out into the first internal space (11a) and into the second internal space (11b), respectively, and each configured to fasten, in a leak-tight manner, an end of a cryogenic jacket (20a, 20b; 20) surrounding at least one superconducting wire (21a, 21b; 21) and to let through at least one superconducting wire (21a, 21b;21) into the first internal space (11a) and into the second internal space (11b), respectively;
• a third opening (13a) of the cryostat housing (1), communicating with the first internal space (11a) and forming an outlet for a cooling fluid flowing in a cryogenic jacket (20a; 20) fastened to the first opening (12a);
• a fourth opening (13b) of the cryostat housing (1), communicating with the second internal space (11b) and forming an inlet for a pressurized cooling fluid flowing in a cryogenic jacket (20b; 20) fastened to the second opening (12b);
the cryostat housing (1) being **characterized in that** said separating partition (10) incorporates a cavity (15) forming at least one partition feedthrough for the passage of at least one superconducting wire (21a, 21b; 21), and an opening (16) for access to said cavity (15) enabling said cavity (15) to be filled with an electrically insulating material injected in polymerizable liquid form in order to make said at least one partition feedthrough leak-tight with regard to cooling fluids after the polymerization of the electrically insulating material.

2. The cryostat housing (1) according to claim 1, **characterized in that** said partition (10) incorporates a plurality of cavities (15) each forming a partition feedthrough for the passage of a wire of a plurality of superconducting wires, and an access opening (16) per cavity (15) for filling each cavity with the electrical insulating material injected in liquid form.

3. The cryostat housing (1) according to claim 1, **characterized in that** said partition wall (10) incorporates a single cavity (15) forming a plurality of partition feedthroughs for the passage of a wire of a plurality of superconducting wires (21₁, 21₂, 21₃₎, filling the single cavity (15) by injection of the electrically insulating material in polymerizable liquid form enabling each partition wall feedthrough to be leak-tight with regard to cooling fluids after the polymerization of the electrically insulating material.

4. The cryostat housing (1) according to either of claims 2 or 3, **characterized in that** same includes at least one fifth opening (13c) for the injection, from an input electrical termination (T₁) external to the cryostat housing, of an electrical current on a first end of a superconducting wire (21) extending through the partition (10).

5. The cryostat housing (1) according to claim 4, **characterized in that**, furthermore, the fifth opening (13c) serves to recover electrical current at a second end of the superconducting wire (21) at an output electrical termination (T₂) external to the cryostat housing.

6. The cryostat housing (1) according to claim 4, **characterized in that** same includes a sixth opening (13d) for allowing electric current to be collected at a second end of the superconducting wire (21) on an output electrical termination (T₂) external to the cryostat housing.

7. The cryostat housing (1) according to any of the preceding claims, **characterized in that** said at least one leak-tight partition feedthrough is dimensioned to receive a connector (3) connecting in series two elementary superconducting wires composing said at least one superconducting wire.

8. The cryostat housing according to any of the preceding claims, **characterized in that** said at least one partition feedthrough comprises two substantially cylindrical ends (18a, 18b) extending transversely on both sides of the separating partition (10), each end (18a, 18b) being equipped with a centering ring (19a, 19b) made of electrically insulating material.

9. A superconducting wired electrical circuit including:
• a first superconducting cable (2a) comprising a first cryogenic jacket (20a) surrounding at least one first superconducting wire (21a) and within which a first cooling fluid flows;
• a second superconducting cable (2b) including a second cryogenic jacket (20b) surrounding at least one second superconducting wire (21b) and within which a second cooling fluid flows
• a cryostat housing (1) according to claim 1 connecting the first superconducting cable (2a) and the second superconducting cable (2b) such that:
- one end of the first cryogenic jacket (20a) is fastened, in a leak-tight manner, to the first opening (12a) of the cryostat housing (1);
- one end of the second cryogenic enclosure (20b) is fastened, in a leak-tight manner, to the second opening (12b) of the cryostat housing (1);
- the first cooling liquid exits through the third opening (13a) of the cryostat housing (1);
- the second cooling liquid enters through the fourth opening (13b) of the cryostat housing (1); and
- said at least one first superconducting wire (21a) and/or said at least one second superconducting wire (21b) extends through the at least one partition feedthrough and is surrounded by polymerized electrical insulating material making the partition feedthrough leak-tight; and
• at least one connector (3) inside the cryostat housing (1) electrically connecting in series the at least one first superconducting wire (21a) and the at least one second superconducting wire (21b).

10. The superconducting wired electrical circuit according to claim 9, wherein said at least one connector (3) is placed in the first internal space (11a) or in the second internal space (11b) of the cryostat housing (1).

11. The superconducting electrical circuit according to claim 9, wherein said at least one connector (3) is located in said at least one leak-tight partition feedthrough.

12. The superconducting wired electrical circuit according to any of claims 9 to 11, **characterized in that** same further includes a cooling liquid management device (4) external to the cryostat housing (1) configured to receive the first cooling liquid exiting the third opening (13a), and to inject the second pressurized cooling liquid through the fourth opening (13b).

13. A superconducting wired electrical circuit forming a closed superconducting electrical loop including:
• a superconducting cable (2) comprising a superconducting wire (21) wound over a plurality of turns and a single cryogenic jacket (20) inside which said turns extend side by side;
• a cryostat package (1) according to any of claims 5 or 6 connected to said superconducting cable (2) so that:
- a first end (20a) of the single cryogenic jacket (20) is fastened, in a leak-tight manner, to the first opening (12a) of the cryostat housing (1);
- a second end (20b) of the single cryogenic enclosure (20) is fastened, in a leak-tight manner, to the second opening (12b) of the cryostat housing (1);
- each turn of the superconducting wire extends through a separate feedthrough of the plurality of partition feedthroughs of the partition wall (10) of said cryostat housing (1), and is surrounded by polymerized electrical insulating material that make each partition feedthrough leak-tight;
- a pressurized cooling liquid enters through the fourth opening (13b) of the cryostat housing (1) and circulates in the single cryogenic enclosure (20);
- said cooling liquid exits through the third opening (13a) of the cryostat housing (1);
• an input electrical termination (T₁) connected to a first end of the superconducting wire (21) through the fifth opening (13c) of the cryostat housing (1) for injecting an electric current into the superconducting wire (21); and
• an output electrical termination (T₂) connected to a second end of the superconducting wire (21) through the fifth opening (13c) or the sixth opening (13d) of the cryostat housing (1) for recovering the electric current flowing through the superconducting wire (21).

14. The superconducting wired electrical circuit according to claim 13, wherein each turn of said superconducting wire is made of a superconducting element wire (21₁, 21₂, 21₃), two successive superconducting element wires being connected in series by a connector (3) placed inside the cryostat housing (1).

15. The superconducting wired electrical circuit according to claim 14, wherein at least one partition feedthrough of said cryostat housing (1) is dimensioned to receive the connector (3) connecting two successive elementary superconducting wires.

16. A superconducting wired electrical circuit including:
• a superconducting cable comprising a cryogenic jacket (20a, 20b) surrounding at least one superconducting wire and inside which a first cooling fluid flows;
• a cryostat housing (1) according to claim 1 connected to said superconducting cable such that:
- the cryogenic jacket (20a, 20b) is fastened, in a leak-tight manner, to the first opening (12a) and to the second opening of the cryostat housing (12b);
- said at least one superconducting wire extends through said at least one partition feedthrough (15) and is surrounded by polymerized electrical insulating material making said partition feedthrough leak-tight;
- a first cooling fluid circulating in the cryogenic jacket (20a, 20b) and entering the cryostat housing (1) through the first opening (12a) exits through the third opening (13a) of the cryostat housing (1);
- a second pressurized cooling fluid enters through the fourth opening (13b) of the cryostat housing (1) and circulates in the cryogenic jacket (20a, 20b) via the second opening (12b).

17. The superconducting wired electrical circuit according to claim 16, **characterized in that** same further includes a cooling liquid management device (4) external to the cryostat housing (1) configured to receive the first cooling liquid exiting the third opening (13a), and to inject the second pressurized cooling liquid through the fourth opening (13b).
